# FASCICULE DE BREVET EUROPEEN

(11) **EP 0 565 428 B1**
(45) Date de publication et mention de la délivrance du brevet: **05.07.1995**
(21) Numéro de dépôt: 93400885.5
(22) Date de dépôt: 05.04.1993
(51) Int. Cl.: H05K 13/00, B62D 5/12

(54) **Dispositif de manutention de cartes de circuit imprimé**
Handhabungsvorrichtung zum Transport von gedruckten Leiterplatten
Printed circuit boards handling device

(30) Priorité: 06.04.1992 FR 9204182
(43) Date de publication de la demande: 13.10.1993
(73) Titulaire: AUTOMA-TECH, F-27000 Evreux (FR)
(72) Inventeur: Sorel, Alain, F-27180 Les Baux Ste Croix (FR); Charbonnier, Serge, F-27120 Chambray (FR)
(74) Mandataire: Dronne, Guy

(56) Documents cités:
- DE-U- 9 005 683
- US-A- 4 323 327
- US-A- 4 619 368

## Description

La présente invention a pour objet un dispositif de manutention de cartes de circuit imprimé.

De façon plus précise, l'invention concerne un dispositif qui permet le transfert d'un poste de travail à un autre de groupes de cartes de circuit imprimé de grandes dimensions.

US-A-4 619 368 divulgue une baie pour supporter des cartes de circuit imprimé. Cette baie comprend une paroi courte reliée à angle droit à une paroi longue. Les parois sont reliées en forme de "L" grâce à des parties inférieures et à des éléments latéraux. Des rainures en "V" sont formées dans les parois. Grâce à une plaque longue, reliée à la paroi longue et faisant fonction de pied, cette baie est apte à se tenir debout sur une surface plate de support de telle sorte que la paroi longue forme un angle de 10° par rapport à la surface de support.

On sait que la réalisation de cartes électroniques nécessite une pluralité d'étapes successives. On peut notamment citer la réalisation sur le support isolant de base des pistes métalliques conductrices, la mise en place des composants sur les pistes conductrices, le soudage à la vague ou par une autre technique des composants sur le circuit imprimé proprement dit et des étapes supplémentaires, par exemple de polymérisation ou d'étuvage.

Le plus souvent, chaque poste de travail est équipé d'une machine de transfert permettant la saisie d'une carte pour déplacer celle-ci d'un dispositif de manutention vers le poste de travail et d'une machine de transfert pour charger la carte de circuit imprimé à sa sortie du poste de travail sur un nouveau dispositif de manutention.

Il est bien sûr nécessaire que ce dispositif de manutention permette un bon positionnement des cartes de circuit imprimé pour faciliter leur saisie à l'aide des moyens de transfert qui sont le plus souvent des bras robotisés. Il faut également que ce dispositif assure un bon maintien des cartes sur le dispositif lors des déplacements d'un poste de travail au suivant pour éviter leur chute et, par ailleurs, que ces dispositifs assurent un accès facile pour la saisie des cartes ou leur mise en place dans le dispositif de manutention.

En outre, il se produit fréquemment que les bras robotisés comportent comme élément de saisie de la carte des ventouses à dépression qui, une fois appliquées sur une des faces de la carte, permettent une saisie de celle-ci avec une grande sécurité et son transfert.

Il faut ajouter que le plus souvent les cartes de circuit imprimé comportent des perçages pour constituer ultérieurement, par exemple, des trous métallisés. On comprend que, si les cartes ne sont pas exactement positionnées les unes par rapport aux autres, de manière que ses trous soient alignées, si les ventouses de saisie des bras robotisés agissent sur une zone incluant un de ces orifices, l'aspiration par effet ventouse risque de provoquer, non seulement la saisie de la première carte, mais également une saisie au moins temporaire de la carte suivante par aspiration à travers les orifices de la première carte.

Un objet de la présente invention est de fournir un dispositif de manutention de cartes de circuit imprimé qui assure un excellent maintien en place des différentes cartes placées sur le dispositif de manutention de manière notamment à conserver l'alignement des orifices percés dans les différentes cartes.

Pour atteindre ce but, selon l'invention, le dispositif de manutention de cartes de circuit imprimé se caractérise en ce qu'il comprend une structure de base sensiblement horizontale et une structure de maintien des cartes solidaire de ladite structure de base, ladite structure de maintien comprenant au moins une paroi inférieure, une paroi latérale et une paroi de fond orthogonales deux à deux, ladite paroi latérale faisant un angle dièdre a avec la verticale et la paroi de fond faisant un angle dièdre b avec la verticale, les angles dièdres a et b étant compris entre 5 et 25 degrés.

On comprend que les parois latérale et inférieure définissent deux plans orthogonaux de référence pour deux côtés consécutifs des différentes cartes et que la paroi de fond constitue une référence pour une des faces de la première carte de la pile placée dans le dispositif de manutention. On comprend également que, grâce aux deux angles dièdres qui sont prévus, d'une part les cartes sont globalement inclinées par rapport à la verticale, ce qui évite tout risque de chute d'une carte lors du déplacement du dispositif de manutention et, d'autre part, l'angle dièdre de la paroi latérale, et en conséquence de la paroi inférieure, tend par effet de gravité à maintenir un des bords "verticaux" de chaque carte en appui contre la paroi latérale. On obtient ainsi un excellent positionnement relatif des différentes cartes et donc l'alignement des orifices percés dans chaque carte du groupe de cartes transporté à l'aide du dispositif de manutention.

D'autres caractéristiques et avantages de la présente invention apparaîtront mieux à la lecture de la description qui suit d'un mode de réalisation de l'invention donné à titre d'exemple non limitatif. La description se réfère aux figures annexées sur lesquelles :
- la figure 1 est une vue en coupe verticale du dispositif de manutention ;
- la figure 2 est une vue en coupe verticale selon la ligne II-II de la figure 1 ; et
- la figure 3 est une vue en perspective du dispositif de maintien.

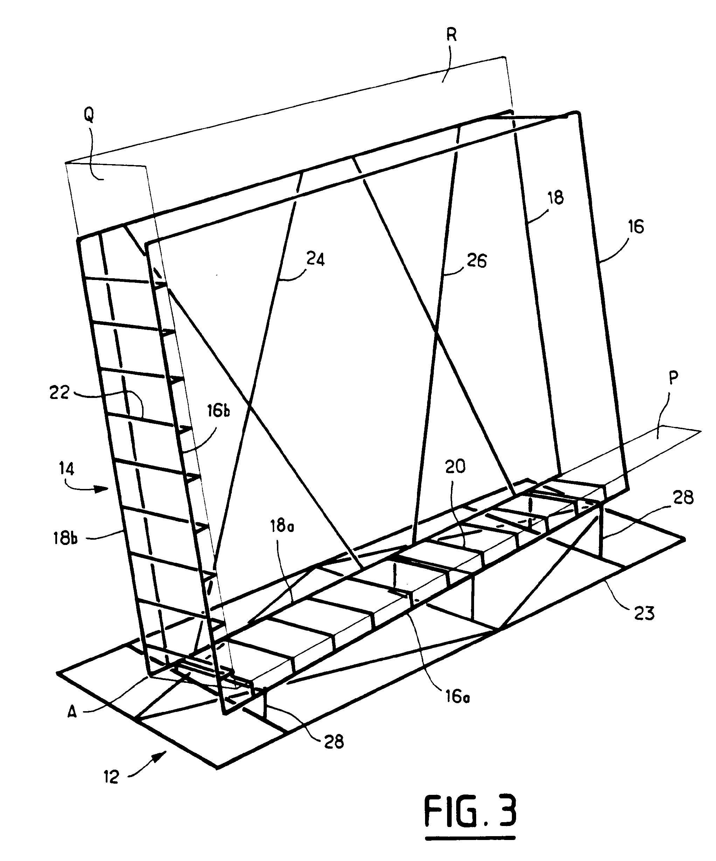

La figure 3 montre que le dispositif de manutention, qui sera ultérieurement appelé cassette de manutention, comporte d'une part une embase 12 définissant une référence horizontale et un ensemble de maintien 14 destiné à recevoir la pile de cartes de circuit imprimé à transporter. Les deux parties 12 et 14 de la cassette sont solidaires entre elles. L'ensemble de maintien 14 est constitué par deux cadres rectangulaires parallèles entre eux, respectivement référencés 16 et 18. Sur leur bord inférieur 16a, 18a les deux cadres sont reliés transversalement par des éléments coudés tels que 20 formés par des tiges. Ces éléments coudés définissent un plan d'appui P pour le bord inférieur des cartes de circuit imprimé. De la même manière, un des bords verticaux 16b, 18b des cadres 16 et 18 est relié par des éléments coudés 22 qui définissent un deuxième plan Q pour un des côtés "verticaux" des cartes de circuit imprimé. Enfin, le cadre 18 est muni de tiges formant croisillon 24 et 26 qui définissent ainsi un troisième plan R pour recevoir une des faces de la première carte de circuit imprimé disposée dans la cassette. Les plans P, Q, R sont orthogonaux deux à deux.

L'embase 12 est constituée par une structure formée par des tiges métalliques telles que 24. La partie inférieure des cadres 16 et 18 respectivement référencés 18a et 16a est reliée de façon rigide à la structure de base 24 par des tiges telles que 28.

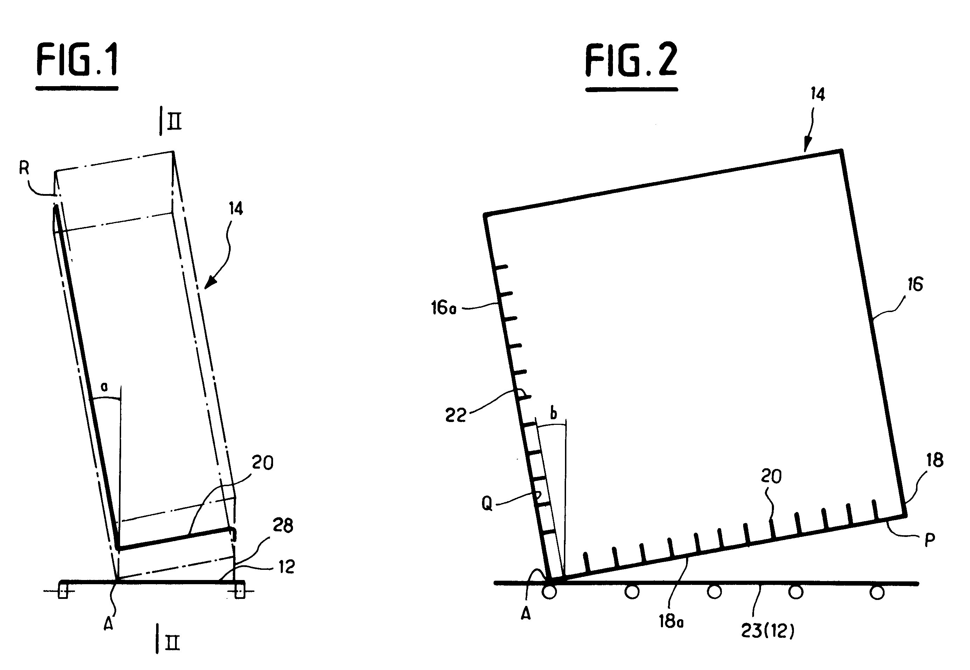

Comme on le voit mieux sur les figures 1 et 2, la structure de maintien 14 présente une double inclinaison par rapport à la structure de base horizontale 12. D'une part, le plan R constituant une paroi de fond de la cassette fait un angle dièdre a avec la verticale. D'autre part, le plan Q définissant la paroi latérale de la cassette fait un angle dièdre b avec la verticale. En conséquence, les droites d'intersection des plans parallèles à R respectivement avec le plan P et le plan horizontal défini par l'embase 12 font des angles b, et les droites d'intersection des plans parallèles à Q respectivement avec le plan P et le plan horizontal défini par l'embase 12 font des angles a.

On comprend que les éléments coudés 20 et 22 et les croisillons 24 et 26 définissent ainsi pour la cassette des cloisons respectivement inférieure, latérale et de fond. On comprend également que les trois autres faces du parallélépipède rectangle qui constitue la cassette sont ouvertes permettant ainsi une introduction commode des cartes de circuit imprimé. Grâce à l'inclinaison de la cloison inférieure correspondant au plan P et subséquemment à l'inclinaison de la cloison latérale correspondant au plan Q, les plaques de circuit imprimé, sous l'effet de la gravité, sont maintenues en appui par un de leurs bords "verticaux" sur le plan Q défini par les éléments coudés 22. Par ailleurs, on comprend que, grâce à l'inclinaison de la cloison de fond définie par le plan R, l'ensemble des cartes présente une inclinaison qui assure leur stabilité lors des déplacements de l'ensemble du dispositif de manutention, tout en évitant que le poids des différentes cartes n'agisse sur les cartes placées en premier, en particulier celle qui est directement en appui sur le plan R, en particulier celle qui est directement en appui sur le plan R, c'est-à-dire sur les croisillons 24 et 26. Si l'on considère l'ensemble de la cassette 14, on voit que le sommet A de celle-ci commun aux plans P, Q et R est le point le plus "bas" de la cassette, c'est-à-dire le plus proche de l'embase 12.

De préférence, les angles dièdres a et b sont compris entre 5 et 25°. Selon un mode de réalisation préféré, ces deux angles dièdres sont égaux à 10°.

On voit qu'avec une telle structure on obtient une superposition parfaite des cartes de circuit imprimé par alignement de leur bord inférieur et de l'un de leurs bords verticaux respectivement selon les plans P et Q. Il en résulte que les orifices ménagés dans ces cartes sont tous alignés permettant ainsi la saisie aisée de chaque carte à l'aide des robots de manutention à système de préhension par dépression. On comprend également que ce dispositif de manutention constitué par des éléments de tige métallique a un poids relativement réduit et qu'il est d'un coût limité.

Enfin la structure en tiges du dispositif de maintien évite les risques d'accumulation de poussières et autres qui risqueraient d'endommager les cartes de circuit imprimé.

## Revendications

1. Dispositif de manutention de cartes de circuits imprimés comprenant une structure de base (12) sensiblement horizontale et une structure de maintien (14) des cartes solidaire de ladite structure de base, ladite structure de maintien comprenant au moins une paroi inférieure (P), une paroi latérale (Q) et une paroi de fond (R) orthogonales entre elles deux à deux, ladite paroi latérale (Q) faisant un angle dièdre a avec la verticale et la paroi de fond (R) faisant un angle dièdre b avec la verticale, les angles dièdres a et b étant compris entre 5 et 25 degrés.

2. Dispositif de manutention selon la revendication 1, caractérisé en ce que les angles dièdres a et b sont de l'ordre de 10 degrés.

3. Dispositif de manutention selon l'une quelconque des revendications 1 et 2, caractérisé en ce que lesdites cloisons latérale (Q), inférieure (P) et de fond (R) sont réalisées à l'aide de tiges (20, 22, 24, 26) solidaires de deux cadres sensiblement rectangulaires (16, 18).

## Patentansprüche

1. Vorrichtung zum Handhaben gedruckter Leiterplatten, mit einer im wesentlichen horizontalen Basisstruktur (12) und einer mit dieser Basisstruktur fest verbundenen Haltestruktur (14) für die Platten, bei der die Haltestruktur zumindest eine untere Wand (P), eine Seitenwand (Q) und eine Rückwand (R) aufweist, die paarweise zueinander rechtwinklig sind, wobei die Seitenwand (Q) mit der Vertikalen einen Flächenwinkel a und die Rückwand (R) mit der Vertikalen einen Flächenwinkel b bildet und die Flächenwinkel a und b zwischen 5° und 25° betragen.

2. Vorrichtung zum Handhaben nach Anspruch 1,
dadurch gekennzeichnet, daß die Flächenwinkel a und b von der Größenordnung 10° sind.

3. Vorrichtung zum Handhaben nach Anspruch 1 oder 2,
dadurch gekennzeichnet, daß die Seitenwand (Q), die untere Wand (P) und die Rückwand (R) mit Hilfe von Stäben (20, 22, 24, 26) gebildet sind, die mit zwei im wesentlichen rechteckigen Rahmen (16, 18) fest verbunden sind.

## Claims

1. Printed circuit boards handling device, comprising a substantially horizontal base structure (12) and a board holding structure (14) integral with the said base structure, the said holding structure comprising at least one lower wall (P), a side wall (Q) and a base wall (R) orthogonal to one another in pairs, the said side wall (Q) forming a dihedral angle a with the vertical and the base wall (R) forming a dihedral angle b with the vertical, the dihedral angles a and b being between 5 and 25 degrees.

2. Handling device according to claim 1, characterised in that the dihedral angles a and b are approximately 10 degrees.

3. Handling device according to either of claims 1 and 2, characterised in that the said side (Q), lower (P) and base partitions (R) are produced with the aid of rods (20, 22, 24, 26) integral with two substantially rectangular frameworks (16, 18).
